# EUROPÄISCHE PATENTSCHRIFT

(11) **EP 3 745 432 B1**
(45) Veröffentlichungstag und Bekanntmachung des Hinweises auf die Patenterteilung: **06.12.2023**
(21) Anmeldenummer: 20174300.2
(22) Anmeldetag: 13.05.2020
(51) Int. Cl.: H01H 1/40, H01H 37/76, H05K 1/18, H01C 7/12

(54) **ÜBERLASTSCHUTZANORDNUNG**
OVERLOAD PROTECTION ARRANGEMENT
AGENCEMENT DE PROTECTION CONTRE LES SURCHARGES

(30) Priorität: 29.05.2019 DE 102019114424
(43) Veröffentlichungstag der Anmeldung: 02.12.2020
(73) Patentinhaber: Phoenix Contact GmbH & Co. KG, 32825 Blomberg (DE)
(72) Erfinder: Lange, Ralf, 32805 Horn-Bad Meinberg (DE); Berg, Peter, 33189 Schlangen (DE); Hermann, Daniel, 33100 Paderborn (DE)
(74) Vertreter: Gesthuysen Patentanwälte

(56) Entgegenhaltungen:
- EP-A1- 1 467 603
- DE-A1- 19 626 275
- US-B2- 8 009 401

## Beschreibung

Die Erfindung geht aus von einer Überlastschutzanordnung zum Schutz eines Überspannungsschutzbauelementes umfassend wenigstens ein Überspannungsschutzbauelement, zwei Anschlusselemente zum Anschluss des Überspannungsschutzbauelementes an den zu schützenden Strom- oder Signalpfad, einen Träger mit Stromführungselementen und wenigstens einen Aktor. wobei das erste Anschlusselement ein thermosensitives Kontaktelement umfasst. Das wenigstens eine Überspannungsschutzbauelement ist in einer ersten Position mit seinem ersten Pol über das thermosensitive Kontaktelement mit dem Träger derart verbunden, dass über das thermosensitive Kontaktelement eine elektrische Verbindung zu dem zu schützenden Stromkreis hergestellt ist. Außerdem ist der zweite Pol des Überspannungsschutzbauelementes über das zweite Anschlusselement mit einem Stromführungselement des Trägers verbunden.

Bei einer thermischen Überbelastung des Überspannungsschutzbauelements ist das Überspannungsschutzbauelement durch den wenigstens einen Aktor in eine zweite Position verbringbar, in der der elektrische Kontakt über das thermosensitive Kontaktelement unterbrochen ist.

Überspannungsschutzanordnungen werden seit Jahrzehnten in unterschiedlichen Ausführungsvarianten zum Schutz von elektrischen Stromkreisen, Anlagen, Maschinen und Geräten eingesetzt. Je nach Anwendungsfall und Schutzstufe weisen die Überspannungsschutzanordnungen dabei unterschiedliche Überspannungsschutzbauelemente und unterschiedliche Bauformen auf. Als Überspannungsschutzbauelemente können sowohl überspannungsbegrenzende Bauelemente wie Varistoren als auch überspannungsschaltende Bauelemente wie Funkenstrecken oder gasgefüllte Überspannungsableiter sowie Kombinationen dieser Bauelemente eingesetzt werden.

Die Überbeanspruchung von solchen Überspannungsschutzbauelementen kann dazu führen, dass sie außerhalb ihres Nennbetriebsbereiches arbeiten. Der beispielsweise durch eine reduzierte Bauteilisolationsfestigkeit hervorgerufene Leistungsumsatz am geschädigten Bauteil kann dann zu einer unzulässigen Erwärmung führen. Wird die unzulässige Erwärmung des Bauelementes nicht verhindert, kann es zur vollständigen Zerstörung des Bauteils und infolge dessen zu einer Schädigung umgebender Materialien und Geräten, Entstehung von Rauchgasen oder zu einer Brandgefahr führen. Daher ist es üblich, derartigen Bauelementen eine Temperatursicherung zuzuordnen, um eine Abschaltung des Bauelements bei Erwärmung zu ermöglichen.

Aus der DE 20 2011 110 007 U1 ist es bekannt, ein Überspannungsschutzbauelement, bei dem es sich insbesondere um einen Varistor handeln kann, auf einem Träger anzuordnen, wobei die beiden Anschlusselemente des Überspannungsschutzbauelementes über jeweils eine thermosensitive Lötverbindung mit einem Stromführungselement auf dem Träger und somit mit dem zu schützenden Stromkreis verbunden sind. Durch eine thermische Überlastung des Überspannungsschutzbauelements schmelzen die Lotverbindungen auf und das Überspannungsschutzbauelement wird durch einen Aktor, bei dem es sich insbesondere um ein Federelement handelt, in eine zweite Position verbracht. In dieser zweiten Position sind die elektrischen Verbindungen beider Anschlusselemente zu den Stromführungselementen getrennt, sodass im Ergebnis das Überspannungsschutzbauelement von dem Stromkreis abgetrennt ist.

Aus der US8009401 B2 ist eine Überlastschutzanordnung bekannt bei der das Überspannungsschutzbauelement nach der Abtrennung durch ein thermosensitives Kontaktelement am ersten Anschlusselement auch verschoben wird, jedoch mit dem als zweites Anschlusselement eingesetzten Litze nur eine mechanische Verbindung mit einer Einkerbung des Trägers als Stromführungselement eingeht. Das Anschlusselement ist in diesem Fall jedoch nicht elektrisch mit einem Stromführungselement des Trägers sondern mit anderen Bauteilen im Gehäuse verbunden.

Ausgehend von diesem Stand der Technik liegt der Erfindung die Aufgabe zugrunde eine Überlastschutzanordnung anzugeben, die besonders einfach ausgebildet ist und eine sichere Abtrennung gewährleistet.

Diese Aufgabe ist bei der Überlastschutzanordnung mit den Merkmalen des Patentanspruchs 1 dadurch gelöst, dass das zweite Anschlusselement derart ausgebildet und angeordnet ist, dass es die Bewegung des Überspannungsschutzbauelementes von der ersten Position in die zweite Position ermöglicht.

Erfindungsgemäß wurde erkannt, dass eine besonders einfache und sichere Abtrennung des Überspannungsschutzbauelementes von dem zu schützenden Stromkreis bei einer Überlastung dadurch erreicht werden kann, dass nur ein elektrischer Kontakt zwischen dem Überspannungsschutzbauelement und dem Stromkreis getrennt wird, während der mechanische Kontakt über das zweite Anschlusselement erhalten bleibt. Hierzu ist das zweite Anschlusselement derart ausgebildet und angeordnet, dass es die Bewegung des Überspannungsschutzbauelementes von der ersten Position in die zweite Position ermöglicht. Beispielsweise kann das zweite Anschlusselement hierzu während der Bewegung des Überspannungsschutzbauelementes eine Formänderung durchführen.

Die erfindungsgemäße Ausführung der Überlastschutzanordnung hat den Vorteil, dass das Überspannungsschutzbauelement auch in der zweiten Position mit dem Träger über das zweite Anschlusselement mechanisch verbunden ist, sodass sich das Überspannungsschutzbauelement nach dem einseitigen Abtrennen nicht unkontrolliert in der Umgebung, beispielsweise in einem Gehäuse bewegt.

Insofern weist die erfindungsgemäße Überlastschutzanordnung eine thermische Abtrenneinrichtung auf, die eine sichere elektrische Abtrennung des Überspannungsschutzbauelements von dem zu schützenden Stromkreis und eine definierte Positionierung und Bewegung des Überspannungsschutzbauelementes gewährleistet.

Im Rahmen der vorliegenden Erfindung ist der Träger insbesondere als Leiterplatte ausgebildet, sodass es sich bei den Stromführungselementen um Leiterbahnen der Leiterplatte handelt.

Besonders bevorzugt ist das thermosensitive Kontaktelement als Niedertemperaturlot ausgebildet, das bei einer thermischen Belastung ab einer bestimmten Temperatur schmilzt oder erweicht. Das zweite Anschlusselement kann dagegen beispielsweise über eine Standardlotverbindung mit dem Träger bzw. einer Leiterbahn bzw. einem Stromführungselement des Trägers verbunden sein. Hierdurch kann gewährleistet werden, dass der Kontakt über das zweite Anschlusselement auch bei einem Schmelzen oder Aufweichen des thermosensitiven Kontaktelementes bestehen bleibt.

Gemäß einer Ausgestaltung der Überlastschutzanordnung ist das zweite Anschlusselement derart ausgebildet und angeordnet ist, dass es die Bewegung des Überspannungsschutzbauelementes von der ersten Position in die zweite Position unterstützt. Beispielsweise weist das zweite Anschlusselement hierzu in der ersten Position eine mechanische Vorspannung auf.

Gemäß einer nächsten Ausgestaltung ist es vorteilhaft, wenn der wenigstens eine Aktor derart ausgestaltet und angeordnet, dass er das wenigstens eine Überspannungsschutzbauelement entlang der Oberfläche des Trägers bewegt. Vorzugsweise bewegt der Aktor das Überspannungsschutzbauelement im Wesentlichen parallel zur Oberfläche. Diese Ausgestaltung ist insbesondere im Hinblick auf die Ausbildung des zweiten Anschlusselementes vorteilhaft, da die Ermöglichung einer geradlinigen Bewegung von der ersten Position in die zweite Position durch ein Stauchen oder ein Strecken des Anschlusselementes besonders einfach realisiert werden kann. Denkbar ist jedoch ebenfalls, dass das Überspannungsschutzbauelement durch den wenigstens einen Aktor vertikal zur Oberfläche des Trägers oder auch schräg dazu bewegt werden kann.

Gemäß einer Ausbildung der Überlastschutzanordnung sind das zweite Anschlusselement und der Aktor an gegenüberliegenden Seiten des Überspannungsschutzbauelementes angeordnet. Ebenfalls denkbar ist jedoch, dass das zweite Anschlusselement und der Aktor an derselben Seite des Überspannungsschutzbauelementes angeordnet sind.

Neben dem zweiten Anschlusselement zur Herstellung einer elektrischen Verbindung des Überspannungsschutzbauelementes mit dem zu schützenden Stromkreis ist gemäß einer weiteren Ausführungsvariante wenigstens ein weiteres mechanisches Anschlusselement vorhanden, über das das Überspannungsschutzbauelement mit dem Träger verbunden ist. Dieses wenigstens eine weitere mechanische Anschlusselement ist ebenfalls derart ausgebildet, dass es die Bewegung des Überspannungsschutzbauelementes von der ersten Position in die zweite Position beispielsweise durch eine Formänderung ermöglicht, vorzugsweise unterstützt. Beispielsweise kann das mechanische Anschlusselement identisch zu dem zweiten elektrischen Anschlusselement ausgebildet sein. Besonders bevorzugt ist das mechanische Anschlusselement derart ausgebildet und angeordnet, dass es eine definierte, vorzugsweise gleichförmige, Bewegung des Überspannungsschutzbauelementes von der ersten Position in die zweite Position unterstützt.

Der wenigstens eine Aktor ist vorzugsweise als Federelement, insbesondere als Druckfeder oder als Zugfeder, ausgebildet. Ist das Federelement derart angeordnet, dass die Federkraft parallel zur Oberfläche des Trägers wirkt, so kann ein Verschieben des Überspannungschutzbauelementes entlang der Oberfläche besonders einfach realisiert werden.

Gemäß einer besonders bevorzugten Ausgestaltung ist wenigstens ein Halteelement vorhanden, das das Überspannungsschutzbauelement im Wesentlichen in der zweiten Position hält. Wenn es heißt, dass das Überspannungsschutzbauelement im Wesentlichen in der zweiten Position gehalten wird, so ist damit gemeint, dass das Überspannungsschutzbauelement durch das Halteelement nicht starr fixiert sein muss, sondern dass kleinere Positionsänderungen zugelassen werden. Bevorzugt ist es jedoch, wenn das Überspannungsschutzbauelement durch das wenigstens eine Halteelement in der zweiten Position fixiert ist.

Bei einer besonders bevorzugten Ausgestaltung ist bzw. sind das zweite Anschlusselement und/oder der Aktor als Halteelement ausgebildet. Das zweite Anschlusselement kann dazu als biegbares Anschlusselement, das vorzugsweise wenigstens eine Biegung oder zwei Biegungen aufweist, ausgebildet sein.

Gemäß einer nächsten Ausgestaltung weist das biegbare Anschlusselement eine Vielzahl von Biegungen auf, sodass das Anschlusselement zumindest abschnittsweise federartig ausgebildet ist. Die Tolerierung der Bewegung von der ersten Position in die zweite Position erfolgt gemäß dieser Ausführung vorzugsweise durch ein Stauchen oder Strecken des federartig ausgebildeten Abschnittes. Das zweite Anschlusselement kann beispielsweise als flexible Litze, als flexibles Blech oder als Zugfederelement oder Druckfederelement ausgebildet sein.

Besonders bevorzugt ist das zweite Anschlusselement selber als Aktor ausgebildet. In diesem Fall kann in vorteilhafter Weise auf ein zusätzliches als Aktor wirkendes Bauelement verzichtet werden. Denkbar ist ebenfalls, dass das zweite Anschlusselement als zweiter Aktor, also zusätzlich zu einem ersten Aktor, ausgebildet ist.

Eine weitere vorteilhafte Ausgestaltung zeichnet sich dadurch aus, dass zumindest bereichsweise zwischen dem zweiten Anschlusselement und dem Träger eine, vorzugsweise verschiebbare, Isolierung angeordnet ist. Die Isolierung gewährleistet insbesondere, dass durch die Bewegung des Überspannungsschutzbauelementes bzw. die Formänderung des zweiten Anschlusselementes das zweite Anschlusselement keinen Kontakt mit dem in der zweiten Position freiliegenden ersten Anschlusselement bzw. dem thermosensitiven Kontaktelement aufweist.

Gemäß einer vorteilhaften Ausgestaltung ist das wenigstens eine Überspannungsschutzbauelement in der ersten Position unter mechanischer Vorspannung, vorzugsweise durch den wenigstens einen Aktor und/oder durch das zweite Anschlusselement, auf dem Träger angeordnet. Schmilzt das thermosensitive Kontaktelement durch eine thermische Überbelastung, so wird das Überspannungsschutzbauelement unmittelbar in die zweite Position bewegt, wodurch der elektrische Kontakt über das thermosensitive Kontaktelement unterbrochen wird.

Das Überspannungsschutzbauelement und der Träger sind vorzugsweise zumindest teilweise in einem Gehäuse angeordnet, wobei ein Anzeigemittel vorhanden ist, dessen Position anzeigt, ob das Überspannungsschutzbauelement in der ersten oder in der zweiten Position angeordnet ist. Hierzu ist in dem Gehäuse ein Sichtfenster angeordnet, so dass das Anzeigemittel zumindest in einer Position des Überspannungsschutzbauelement von außerhalb des Gehäuses erkennbar ist.

Besonders bevorzug ist das Anzeigemittel an dem Überspannungsschutzbauelement, beispielsweise in Form einer farblichen Markierung, angeordnet und/oder das Anzeigemittel ist als separates Bauteil mit dem Überspannungsschutzbauelement verbunden. Im einfachsten Fall ist das Anzeigemittel durch das Überspannungsschutzbauelement selbst ausgebildet.

Gemäß einer Ausgestaltung wird das Anzeigemittel durch die Bewegung des Überspannungsschutzbauelementes von der ersten Position in die zweite Position ebenfalls bewegt. Weist das Gehäuse ein Sichtfenster auf, wobei die Bewegung des Anzeigemittels durch das Sichtfenster wahrnehmbar ist, kann ein abgetrenntes Überspannungsschutzbauelement von außen leicht erfasst werden.

Gemäß einer weiteren Ausbildung weist die Überlastschutzanordnung zwei Überspannungsschutzbauelemente auf, wobei auch das zweite Überspannungsschutzbauelement über zwei weitere Anschlusselemente auf dem Träger angeordnet ist. Das erste Anschlusselement des zweiten Überspannungsschutzbauelementes umfasst ebenfalls ein thermosensitives Kontaktelement. Das zweite Überspannungsschutzbauelement ist dabei in der ersten Position mit seinem ersten Pol über das thermosensitive Kontaktelement mit dem Träger derart verbunden, dass über das thermosensitive Kontaktelement eine elektrische Verbindung zu dem zu schützenden Stromkreis hergestellt ist. Der zweite Pol des zweiten Überspannungsschutzbauelementes ist über das zweite Anschlusselement mit einem Stromführungselement des Träger verbunden, wobei das zweite Überspannungsschutzbauelement bei einer thermischen Überbelastung durch einen Aktor in eine zweite Position verbringbar ist, in der der elektrische Kontakt über das thermosensitive Kontaktelement unterbrochen ist. Das zweite Anschlusselement ist dabei derart ausgebildet und angeordnet, dass es die Bewegung des Überspannungsschutzbauelementes von der ersten Position in die zweite Position ermöglicht. Der Träger und die beiden Überspannungsschutzbauelemente sind dabei zumindest teilweise in einem Gehäuse angeordnet, wobei ein Anzeigemittel vorhanden ist, durch dessen Positionvon außerhalb des Gehäuses erkennbar ist, ob wenigstens ein Überspannungsschutzbauelement in der zweiten Position angeordnet ist.

Gemäß einer Ausgestaltung der zuvor beschriebenen Überlastschutzanordnung umfassend zwei Überspannungsschutzbauelemente ist das Anzeigemittel als Schieber ausgebildet, der bewegt wird, sobald eines der Überspannungsschutzbauelemente auf Grund einer thermischen Überbelastung in die zweite Position verbracht wird. Weist das Gehäuse ein Sichtfenster auf, so ist das Anzeigemittel bzw. der Schieber vorzugweise derart angeordnet, dass der Schieber vor das Sichtfenster geschoben wird, wenn wenigstens eines der beiden Überspannungsschutzbauelemente von einer ersten in eine zweite Position bewegt wird. Zusätzlich weist der Schieber gemäß einer weiteren Ausgestaltung eine weitere Fixierungseinrichtung auf, die in der zweiten Position verhindert, dass das Überspannungsschutzbaulement sich zurück in die ersten Position bewegt.

Im Einzelnen gibt es nun eine Vielzahl von Möglichkeiten, die erfindungsgemäße Überlastschutzanordnung auszugestalten und weiterzubilden. Dazu wird verwiesen sowohl auf die dem unabhängigen Patentanspruch nachgeordneten Patentansprüche als auch auf die nachfolgende Beschreibung von bevorzugten Ausführungsbeispielen in Verbindung mit der Zeichnung. In der Zeichnung zeigen
- Fig. 1: ein erstes Ausführungsbeispiel einer erfindungsgemäßen Überlastschutzanordnung in einer ersten Position, in einer Schnittansicht,
- Fig. 2: die Überlastschutzanordnung gemäß Fig. 1, in einer zweiten Position in einer Schnittansicht,
- Fig. 3: das erste Ausführungsbeispiel in der ersten Position in einer Ansicht von oben,
- Fig. 4: das erste Ausführungsbeispiel in der zweiten Position in einer Ansicht von oben,
- Fig. 5: ein zweites Ausführungsbeispiel einer erfindungsgemäßen Überlastschutzanordnung in einer ersten Position,
- Fig. 6: das zweite Ausführungsbeispiel in einer zweiten Position,
- Fig. 7: ein drittes Ausführungsbeispiel einer erfindungsgemäßen Überlastschutzanordnung in einer ersten Position,
- Fig. 8: das dritte Ausführungsbeispiel in einer zweiten Position,
- Fig. 9: ein viertes Ausführungsbeispiel einer erfindungsgemäßen Überlastschutzanordnung in einer ersten Position,
- Fig. 10: das vierte Ausführungsbeispiel in einer zweiten Position,
- Fig. 11: ein fünftes Ausführungsbeispiel einer erfindungsgemäßen Überlastschutzanordnung in einer ersten Position,
- Fig. 12: das fünfte Ausführungsbeispiel in einer zweiten Position,
- Fig. 13: ein sechstes Ausführungsbeispiel einer erfindungsgemäßen Überlastschutzanordnung in einer ersten Position,
- Fig. 14: das sechste Ausführungsbeispiel in einer zweiten Position,
- Fig. 15: ein siebtes Ausführungsbeispiel einer erfindungsgemäßen Überlastschutzanordnung in ersten Position,
- Fig. 16: das siebte Ausführungsbeispiel in einer zweiten Position,
- Fig. 17: ein achtes Ausführungsbeispiel einer erfindungsgemäßen Überlastschutzanordnung,
- Fig. 18: ein neuntes Ausführungsbeispiel einer erfindungsgemäßen Überlastschutzanordnung in einer ersten Position und
- Fig. 19: das neunte Ausführungsbeispiel in einer zweiten Position.

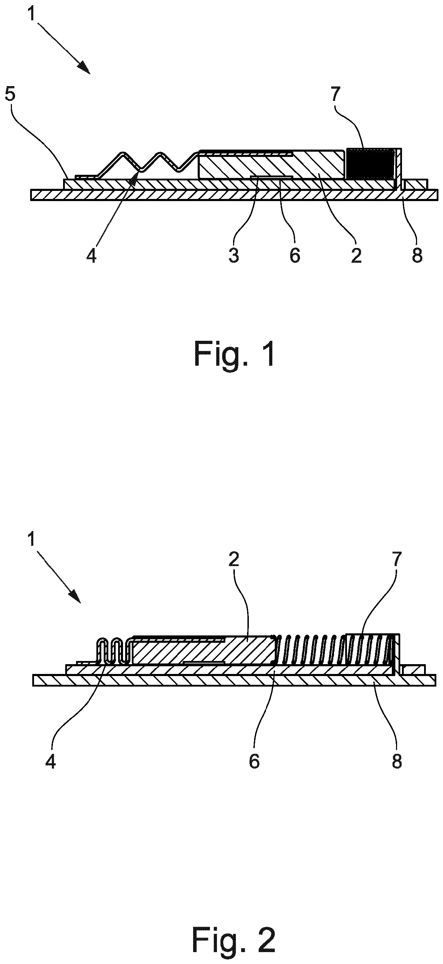

Fig. 1 zeigt ein erstes Ausführungsbeispiel einer Überlastschutzanordnung 1 zum Schutz eines Überspannungsschutzbauelementes 2 in einer Schnittansicht. Die Überlastschutzanordnung 1 umfasst ein Überspannungsschutzbauelement 2, das über ein erstes Anschlusselement 3 und über ein zweites Anschlusselement 4 mit auf dem Träger 5, der hier als Leiterplatte ausgebildet ist, angeordneten Stromführungselementen elektrisch verbunden ist.

Das erste Anschlusselement 3 umfasst im dargestellten Ausführungsbeispiel ein thermosensitives Kontaktelement 6. Im Detail ist das in Fig. 1 gezeigte thermosensitive Kontaktelement 6 als Niedertemperaturlot ausgestaltet und bildet insofern eine thermische Abtrennstelle des Überspannungsschutzbauelementes 2. Bei einer thermischen Überbelastung schmilzt das thermosensitive Kontaktelement 6 auf, wodurch die durch das Kontaktelement 6 gebildete mechanische Verbindung getrennt wird.

Zudem ist ein Aktor 7 in Form einer Druckfeder vorhanden, wobei der Aktor 7 in der dargestellten ersten Position unter mechanischer Vorspannung gegenüber dem Gehäuse 8 montiert ist. Löst sich die mechanische Verbindung, die durch das thermosensitive Kontaktelement 6 hergestellt ist, so verschiebt der Aktor 7 das Überspannungsschutzbauelement 2 entlang der Oberfläche des Trägers 5 in eine zweite Position. Dies ist in Fig. 2 dargestellt.

Das zweite Anschlusselement 4 ist über eine Standardlotverbindung mit dem Träger 5 verbunden. Zudem ist das zweite Anschlusselement 4 abschnittsweise federartig ausgebildet. Das zweite Anschlusselement 4 und der die als Aktor 7 wirkende Druckfeder sind an dem Überspannungsschutzbauelement einander gegenüberliegend angeordnet.

Die Darstellung in Fig. 2 zeigt die zweite Position des Überspannungsschutzbauelementes 2. In dieser Position ist die elektrische Verbindung über das thermosensitive Kontaktelement 6 auf Grund der Verschiebung des Überspannungsschutzbauelementes 2 unterbrochen. Das zweite Anschlusselement 4 hat sich durch die Bewegung des Überspannungsschutzbauelementes 2 verformt, im Detail wurde der federartig ausgebildete Teil des Anschlusselementes 4 gestaucht. Das zweite Anschlusselement 4 ist damit auch in der zweiten Position mit dem Träger 5 und dem Überspannungsschutzbauelement 2 verbunden.

Die dargestellte Ausgestaltung der Überlastschutzanordnung 1 weist damit den Vorteil auf, dass sowohl während der Bewegung als auch in der zweiten Position über das zweite Anschlusselement 4 eine mechanische Verbindung des Überspannungsschutzbaulementes 2 zu dem Träger 5 besteht, wodurch einerseits eine definierte Bewegung von der ersten Position in die zweite Position gewährleistet werden kann und wodurch weiterhin garantiert ist, dass das Überspannungsschutzbauelement 2 nach der Trennung der mechanischen Verbindung über das thermosensitive Kontaktelement 6 sich nicht unkontrolliert im Gehäuse 8 bewegt.

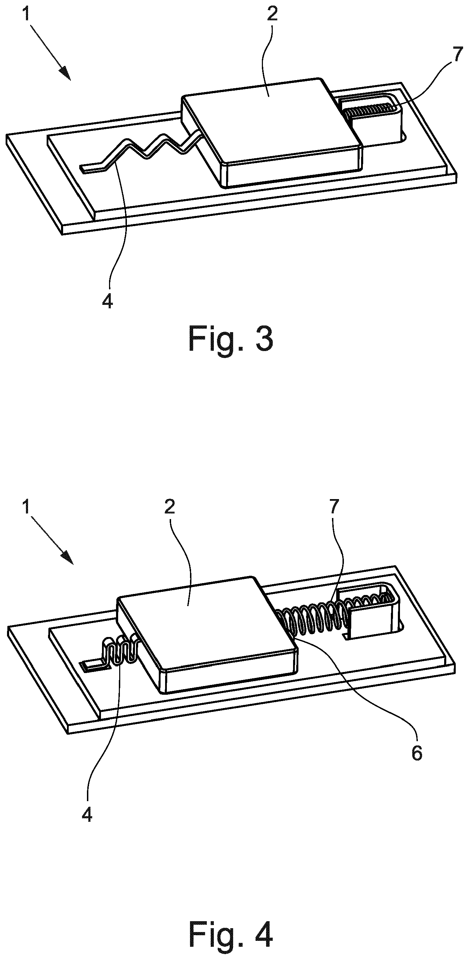

Die Fig. 3 und 4 zeigen das erste Ausführungsbeispiel einer thermischen Überlastschutzanordnung 1 in der ersten Position und in der zweiten Position in einer Ansicht von oben. Das zweite Anschlusselement 4 ist in dem dargestellten Ausführungsbeispiel derart angeordnet, dass es mittig gegenüberliegend von dem Aktor 7 an dem Überspannungsschutzbauelement 2 angeordnet ist. Insofern kann gewährleistet werden, dass das Überspannungsschutzbauelement 2 eine geradlinige Bewegung von der ersten Position in die zweite Position durchführt.

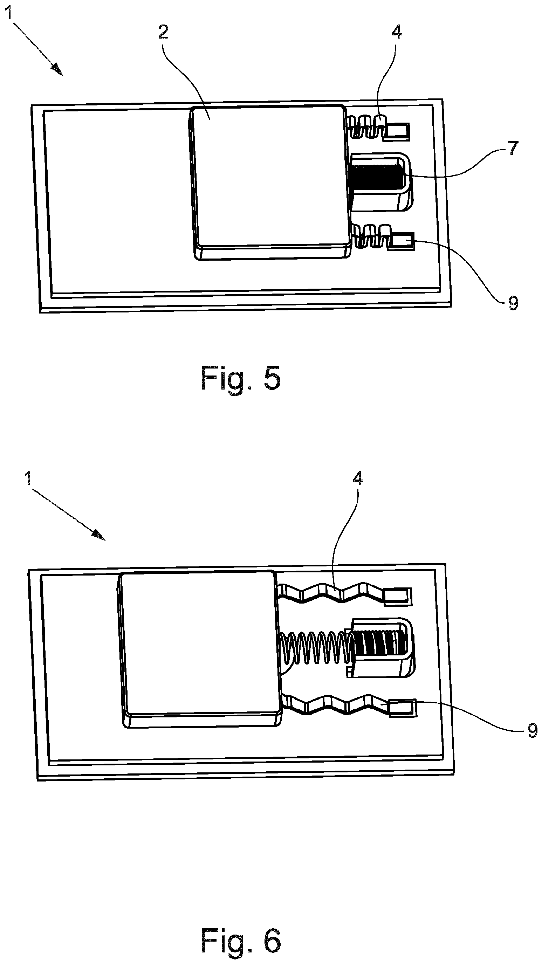

In dem in Fig. 5 gezeigten zweiten Ausführungsbeispiel einer Überlastschutzanordnung 1 ist neben dem zweiten Anschlusselement 4 ein weiteres mechanisches Anschlusselement 9 vorhanden, das das Überspannungsschutzbauelement 2 mit dem Träger 5 mechanisch verbindet. Im Unterschied zu dem in den Fig. 1 bis 4 dargestellten Ausführungsbeispiel sind das zweite Anschlusselement 4 und der Aktor 7 auf derselben Seite des Überspannungsschutzbauelementes 2 angeordnet. In der zweiten Position wird das zweite Anschlusselement im Gegensatz zu den vorherigen Darstellungen gestreckt und nicht gestaucht. Nicht zu sehen ist, dass die thermische Trennstelle ebenso wie in dem ersten Ausführungsbeispiel im Wesentlichen mittig unterhalb des Überspannungsschutzbauelementes angeordnet ist. Dies gilt ebenso für sämtliche weiteren Ausführungsbeispiele. Damit die Verschiebung gleichförmig geradlinig und nicht schief erfolgt, ist das die Bewegung des Überspannungsschutzbauelementes 2 unterstützende mechanische Anschlusselement 9 ebenfalls auf der derselben Seite wie das zweite Anschlusselement 4 und der Aktor 7 angeordnet.

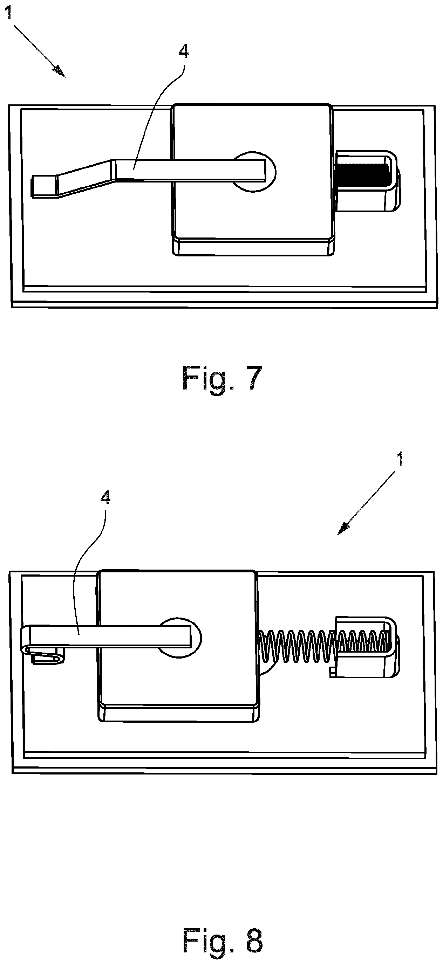

In den Fig. 7 und 8 ist ein weiteres Ausführungsbeispiel einer thermischen Überlastschutzanordnung 1 in einer ersten Position (Fig. 7) und in einer zweiten Position (Fig. 8) dargestellt. In dem dargestellten Ausführungsbeispiel ist das zweite Anschlusselement 4 als flexible Litze ausgebildet.

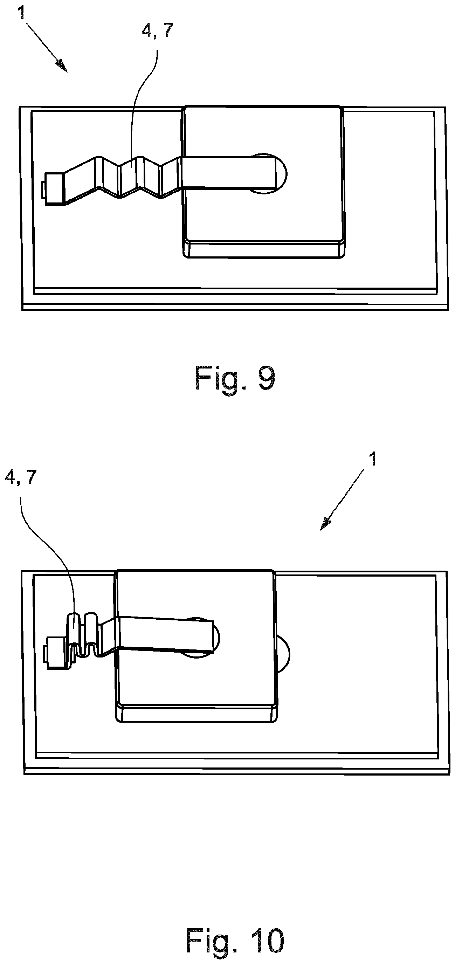

Die Fig. 9 und 10 zeigen ein viertes Ausführungsbeispiel einer thermischen Überlastschutzanordnung 1, in der das zweite Anschlusselement 4 als federndes Blech ausgebildet ist, das in der zweiten Position gestaucht ist. Zudem ist das zweite Anschlusselement 4 selbst als Zugfederelement und insofern als Aktor 7 ausgebildet, sodass in vorteilhafter Weise auf eine weiteres Aktorelement 7 verzichtet werden kann.

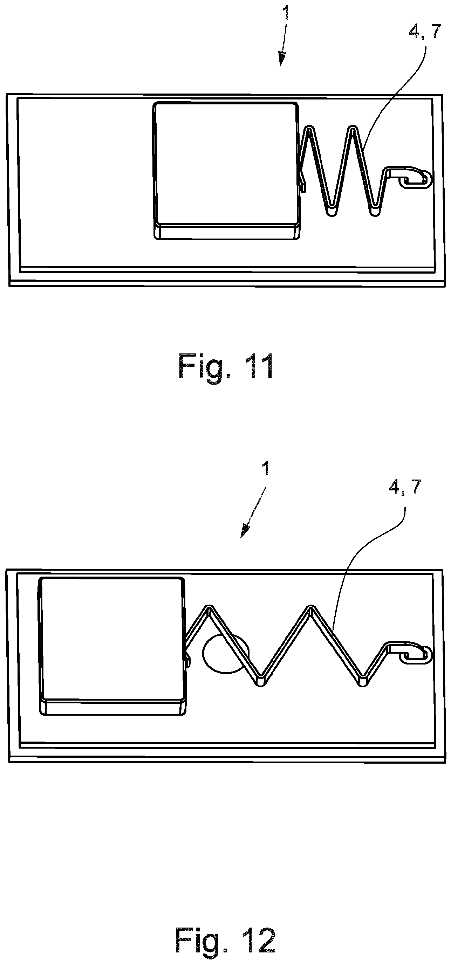

In dem in den Fig. 11 und 12 dargestellten fünften Ausführungsbeispiel ist das zweite Anschlusselement 4 als Druckfederelement und insofern ebenfalls als Aktor 7 ausgebildet.

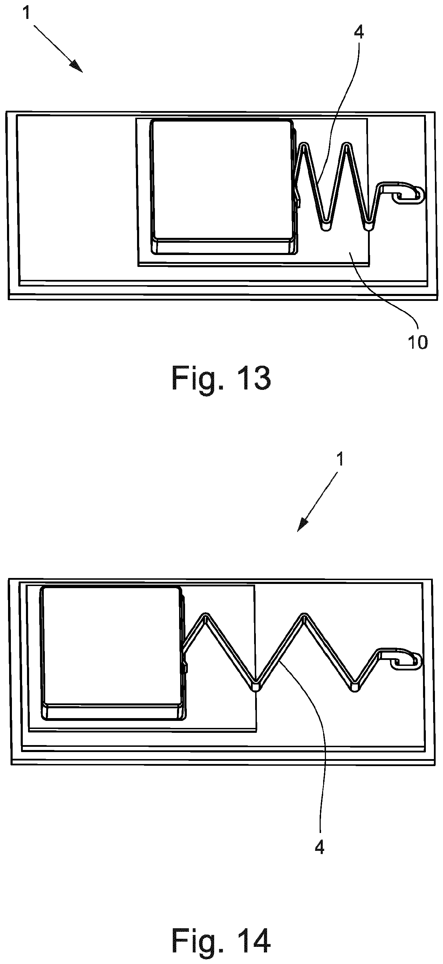

In dem in den Fig. 13 und 14 dargestellten Ausführungsbeispiel ist zusätzlich eine Isolierung 10 zwischen dem als Druckfeder ausgebildeten zweiten Anschlusselement 4 und dem Träger 5 angeordnet, wobei die Isolierung 10 insbesondere in der in Fig. 14 gezeigten zweiten Position verhindert, dass das Anschlusselement 4 in elektrischen Kontakt mit dem ersten Anschlusselement 3 bzw. dem thermosensitiven Kontaktelement 6 gerät.

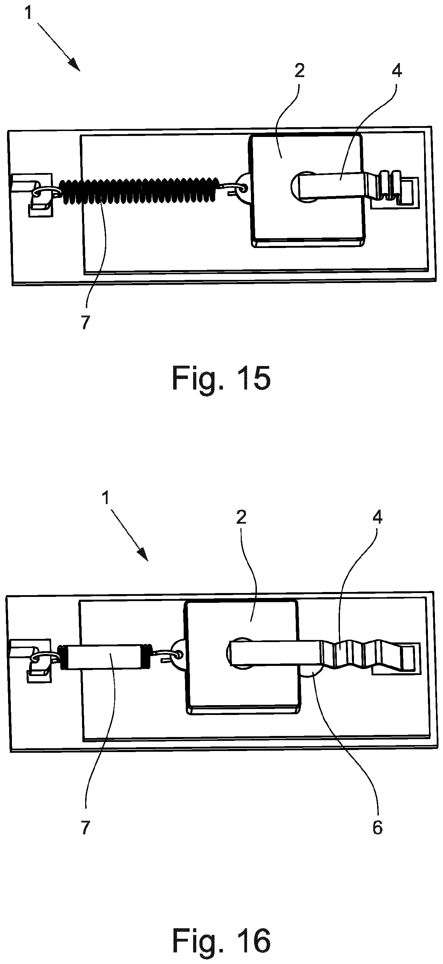

Die Fig. 15 und 16 zeigen ein nächstes Ausführungsbeispiel einer Überlastschutzanordnung 1, wobei der Aktor 7 als Zugfeder ausgebildet ist.

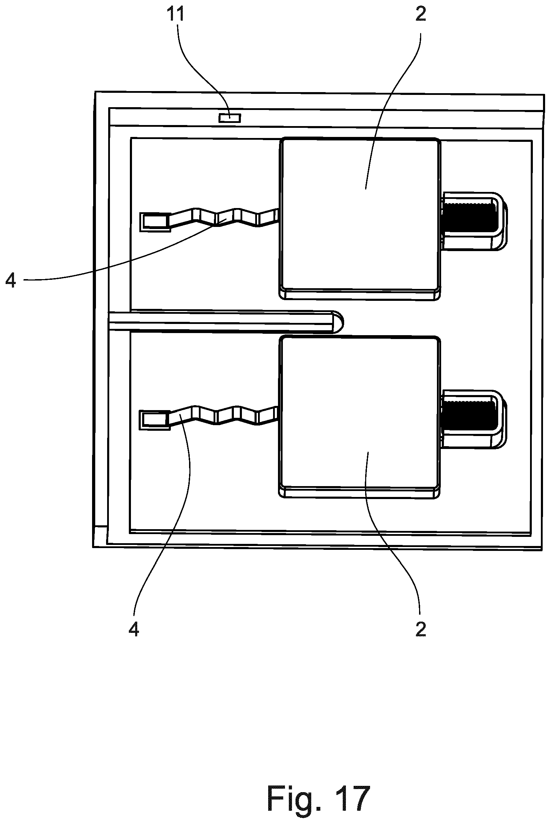

Das in dem in Fig. 17 dargestellte achte Ausführungsbeispiel einer thermischen Überlastschutzanordnung 1 weist zwei Überspannungsschutzelemente 2 auf, die gleichermaßen über zwei Anschlusselemente 3, 4 auf einem Träger 5 angeordnet sind. Die beiden Überspannungsschutzbauelement 2 sind in einem Gehäuse 8 angeordnet. Das Gehäuse 8 weist ein Sichtfenster 11 auf, wobei das erste Überspannungsschutzbauelement 2 in der zweiten Position vor dem Sichtfenster 11 angeordnet ist. Insofern ist außerhalb des Gehäuses 8 erkennbar, wenn das erste Überspannungsschutzbauelement 2 aufgrund einer thermischen Überbelastung bewegt wurde.

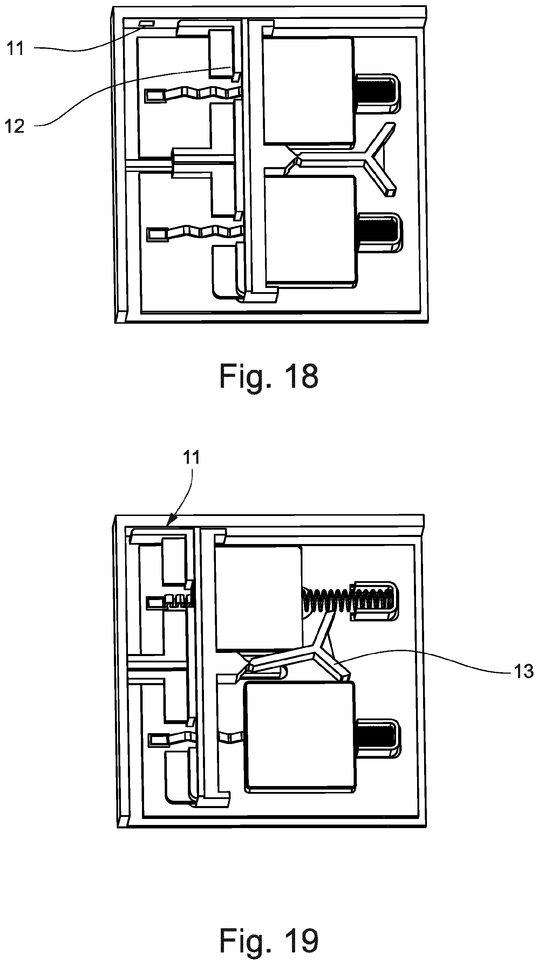

In Erweiterung dazu weist das in den Fig. 18 und 19 dargestellte Ausführungsbeispiel ein Anzeigemittel 12 in Form eines Schiebers auf, wobei der Schieber vor das Sichtfenster 11 geschoben wird, wenn wenigstens eines der beiden Überspannungsschutzbauelemente 2 von einer ersten in eine zweite Position bewegt wird. Zusätzlich weist der Schieber eine weitere Fixierungseinrichtung 13 auf, die in der zweiten Position verhindert, dass das Überspannungsschutzbaulement 2 sich zurück in die ersten Position bewegt.

### Bezugszeichen

- 1: Überlastschutzanordnung
- 2: Überspannungsschutzbauelement
- 3: erstes Anschlusselement
- 4: zweites Anschlusselement
- 5: Träger
- 6: thermosensitives Kontaktelement
- 7: Aktor
- 8: Gehäuse
- 9: mechanisches Anschlusselement
- 10: Isolierung
- 11: Sichtfenster
- 12: Anzeigemittel
- 13: Fixierungseinrichtung

## Patentansprüche

1. Überlastschutzanordnung (1) zum Schutz eines Überspannungsschutzbauelementes (2) umfassend wenigstens ein Überspannungsschutzbauelement (2), zwei Anschlusselemente (3, 4) zum Anschluss des Überspannungsschutzbauelementes (2) an den zu schützenden Strom- oder Signalpfad, einen Träger (5) mit Stromführungselementen und wenigstens einem Aktor (7),
wobei das erste Anschlusselement (3) ein thermosensitives Kontaktelement (6) umfasst,
wobei das wenigstens eine Überspannungsschutzbauelement (2) in einer ersten Position mit seinem ersten Pol über das thermosensitive Kontaktelement (6) mit dem Träger (5) derart verbunden ist, dass über das thermosensitive Kontaktelement (6) eine elektrische Verbindung zu dem zu schützenden Stromkreis herstellbar ist,
wobei der zweite Pol des Überspannungsschutzbauelementes (2) über das zweite Anschlusselement (4) mit einem Stromführungselement des Trägers (5) elektrisch verbunden ist, und
wobei das wenigstens eine Überspannungsschutzbauelement (2) bei einer thermischen Überbelastung durch den wenigstens einen Aktor (7) in eine zweite Position verbringbar ist, in der der elektrische Kontakt über das thermosensitive Kontaktelement (6) unterbrochen ist, und wobei das zweite Anschlusselement (4) derart ausgebildet und angeordnet ist, dass es die Bewegung des Überspannungsschutzbauelementes (2) von der ersten Position in die zweite Position ermöglicht.

2. Überlastungsschutzanordnung (1) nach Anspruch 1, **dadurch gekennzeichnet, dass** das zweite Anschlusselement (4) derart ausgebildet und angeordnet ist, dass es die Bewegung des Überspannungsschutzbauelementes (2) von der ersten Position in die zweite Position unterstützt.

3. Überlastungsschutzanordnung (1) nach Anspruch 1 oder 2, **dadurch gekennzeichnet, dass** der wenigstens eine Aktor (7) derart ausgestaltet und angeordnet ist, dass er das wenigstens eine Überspannungsschutzbauelement (2) entlang der Oberfläche des Trägers (5) bewegt.

4. Überlastungsschutzanordnung (1) nach einem der Ansprüche 1 bis 3, **dadurch gekennzeichnet, dass** der Aktor (7) als Federelement, vorzugsweise als Druckfeder oder als Zugfeder, ausgebildet ist.

5. Überlastungsschutzanordnung (1) nach einem der Ansprüche 1 bis 4, **dadurch gekennzeichnet, dass** wenigstens ein Halteelement vorhanden ist, das das Überspannungsschutzbauelement (2) nach einer thermischen Überbelastung im Wesentlichen in der zweiten Position hält.

6. Überlastungsschutzanordnung (1) nach Anspruch 5, **dadurch gekennzeichnet, dass** das zweite Anschlusselement (4) und/oder der Aktor (7) als Halteelement ausgebildet ist bzw. sind.

7. Überlastungsschutzanordnung (1) nach einem der Ansprüche 1 bis 6, **dadurch gekennzeichnet, dass** das zweite Anschlusselement (4) als biegbares Anschlusselement, das vorzugsweise wenigstens eine Biegung aufweist, ausgebildet ist.

8. Überlastungsschutzanordnung (1) nach einem der Ansprüche 1 bis 7, **dadurch gekennzeichnet, dass** das zweite Anschlusselement (4) als flexible Litze und/oder als flexibles Blech und/oder als Zugfederelement und/oder als Druckfederelement ausgebildet ist.

9. Überlastungsschutzanordnung (1) nach einem der Ansprüche 1 bis 7, **dadurch gekennzeichnet, dass** das zweite Anschlusselement (4) als Aktor (7) ausgebildet ist.

10. Überlastungsschutzanordnung (1) nach einem der Ansprüche 1 bis 9, **dadurch gekennzeichnet, dass** das wenigstens eine Überspannungsschutzbauelement (2) in der ersten Position unter mechanischer Vorspannung angeordnet ist.

11. Überlastungsschutzanordnung (1) nach einem der Ansprüche 1 bis 10, **dadurch gekennzeichnet, dass** das Überspannungsschutzbauelement (2) und der Träger (5) zumindest teilweise in einem Gehäuse (8) angeordnet sind, wobei ein Anzeigemittel (11) vorhanden ist, durch dessen Position von außerhalb des Gehäuses (8) erkennbar ist, ob das Überspannungsschutzbauelement (2) in der ersten oder der zweiten Position angeordnet ist.

12. Überlastschutzanordnung (1) nach Anspruch 11, **dadurch gekennzeichnet, dass** das Anzeigemittel (11) an dem Überspannungsschutzbauelement (2) angeordnet ist und/oder dass das Anzeigemittel (11) als separates Bauteil mit dem Überspannungsschutzbauelement (2) verbunden ist.

13. Überlastschutzanordnung (1) nach einem der Ansprüche 1 bis 12, **dadurch gekennzeichnet, dass** ein zweites Überspannungsschutzbauelement (2) über zwei weitere Anschlusselemente (3, 4) auf dem Träger (5) angeordnet ist,
wobei das erste Anschlusselement (3) des zweiten Überspannungsschutzbauelementes (2) ein thermosensitives Kontaktelement (6) umfasst,
wobei das zweite Überspannungsschutzbauelement (2) in der ersten Position mit seinem ersten Pol über das thermosensitive Kontaktelement (6) mit dem Träger (5) derart verbunden ist, dass über das thermosensitive Kontaktelement (6) eine elektrische Verbindung zu dem zu schützenden Stromkreis hergestellt ist,
wobei weiterhin der zweite Pol des zweiten Überspannungsschutzbauelementes (2) über das zweite Anschlusselement (4) mit einem Stromführungselement des Träger (5) verbunden ist,
wobei das zweite Überspannungsschutzbauelement (2) bei einer thermischen Überbelastung durch einen Aktor (7) in eine zweite Position verbringbar ist, in der der elektrische Kontakt über das thermosensitive Kontaktelement (6) unterbrochen ist,
wobei das zweite Anschlusselement (4) derart ausgebildet und angeordnet ist, dass es die Bewegung des Überspannungsschutzbauelementes (2) von der ersten Position in die zweite Position ermöglicht,
wobei der Träger (5) und das erste Überspannungsschutzbauelement (2) und das zweite Überspannungsschutzbauelement (2) zumindest teilweise in einem Gehäuse (8) angeordnet sind und
wobei ein Anzeigemittel (11) vorhanden ist, wobei durch die Position des Anzeigemittels außerhalb des Gehäuses (8) erkennbar ist, ob wenigstens ein Überspannungsschutzbauelement (2) in der zweiten Position angeordnet ist.

## Claims

1. Overload protection arrangement (1) for protecting an overvoltage protection component (2) comprising at least one overvoltage protection component (2), two connection elements (3, 4) for connecting the overvoltage protection component (2) to the current or signal path to be protected, a carrier (5) with current carrying elements and at least one actuator (7),
wherein the first connection element (3) comprises a thermosensitive contact element (6),
wherein the at least one overvoltage protection component (2) is connected in a first position with its first pole via the thermosensitive contact element (6) to the carrier (5) in such a way that an electrical connection to the circuit to be protected can be established via the thermosensitive contact element (6),
wherein the second pole of the overvoltage protection component (2) is electrically connected to a current carrying element of the carrier (5) via the second connection element (4), and
wherein the at least one overvoltage protection component (2), in the event of a thermal overload by the at least one actuator (7), can be brought into a second position in which the electrical contact is interrupted via the thermosensitive contact element (6), and
wherein the second connection element (4) is designed and arranged in such a way that it enables the movement of the overvoltage protection component (2) from the first position into the second position.

2. Overload protection arrangement (1) according to claim 1, **characterized in that** the second connection element (4) is designed and arranged in such a way that it supports the movement of the overvoltage protection component (2) from the first position into the second position.

3. Overload protection arrangement (1) according to claim 1 or 2, **characterized in that** the at least one actuator (7) is designed and arranged in such a way that it moves the at least one overvoltage protection component (2) along the surface of the carrier (5).

4. Overload protection arrangement (1) according to any one of claims 1 to 3, **characterized in that** the actuator (7) is designed as a spring element, preferably as a compression spring or as a tension spring.

5. Overload protection arrangement (1) according to any one of claims 1 to 4, **characterized in that** at least one retaining element is provided which retains the overvoltage protection component (2) essentially in the second position after a thermal overload.

6. Overload protection arrangement (1) according to claim 5, **characterized in that** the second connection element (4) and/or the actuator (7) is/are designed as a retaining element.

7. Overload protection arrangement (1) according to any one of claims 1 to 6, **characterized in that** the second connection element (4) is designed as a bendable connection element which preferably has at least one bend.

8. Overload protection arrangement (1) according to any one of claims 1 to 7, **characterized in that** the second connection element (4) is designed as a flexible stranded wire and/or as a flexible metal sheet and/or as a tension spring element and/or as a compression spring element.

9. Overload protection arrangement (1) according to any one of claims 1 to 7, **characterized in that** the second connection element (4) is designed as an actuator (7).

10. Overload protection arrangement (1) according to any one of claims 1 to 9, **characterized in that** the at least one overvoltage protection component (2) is arranged in the first position under mechanical prestress.

11. Overload protection arrangement (1) according to any one of claims 1 to 10, **characterized in that** the overvoltage protection component (2) and the carrier (5) are arranged at least partially in a housing (8), wherein an indicating means (11) is provided, by means of whose position it is recognizable from outside the housing (8) whether the overvoltage protection component (2) is arranged in the first or the second position.

12. Overload protection arrangement (1) according to claim 11, **characterized in that** the indicating means (11) is arranged on the overvoltage protection component (2) and/or that the indicating means (11) is connected to the overvoltage protection component (2) as a separate component.

13. Overload protection arrangement (1) according to any one of claims 1 to 12, **characterized in that** a second overvoltage protection component (2) is arranged on the carrier (5) via two further connection elements (3, 4),
wherein the first connection element (3) of the second overvoltage protection component (2) comprises a thermosensitive contact element (6),
wherein the second overvoltage protection component (2) is connected in the first position with its first pole via the thermosensitive contact element (6) to the carrier (5) in such a way that an electrical connection to the circuit to be protected is established via the thermosensitive contact element (6),
wherein furthermore the second pole of the second overvoltage protection component (2) is connected to a current carrying element of the carrier (5) via the second connection element (4),
wherein the second overvoltage protection component (2), in the event of a thermal overload, can be brought by an actuator (7) into a second position in which the electrical contact is interrupted via the thermosensitive contact element (6),
wherein the second connection element (4) is designed and arranged in such a way that it enables the movement of the overvoltage protection component (2) from the first position to the second position,
wherein the carrier (5) and the first overvoltage protection component (2) and the second overvoltage protection component (2) are at least partially arranged in a housing (8), and
wherein an indicating means (11) is provided, wherein the position of the indicating means outside the housing (8) indicates whether at least one overvoltage protection component (2) is arranged in the second position.

## Revendications

1. Agencement de protection contre les surcharges (1) permettant de protéger un composant de protection contre les surtensions (2), comprenant au moins un composant de protection contre les surtensions (2), deux éléments de connexion (3, 4) permettant de connecter le composant de protection contre les surtensions (2) au trajet de courant ou de signal à protéger, un support (5) pourvu d'éléments conducteurs de courant, et au moins un actionneur (7),
dans lequel le premier élément de connexion (3) comprend un élément de contact thermosensible (6),
dans lequel, dans une première position, ledit au moins un composant de protection contre les surtensions (2) est relié au support (5) par son premier pôle par l'intermédiaire de l'élément de contact thermosensible (6) de telle sorte qu'une liaison électrique avec le circuit électrique à protéger peut être établie par l'intermédiaire de l'élément de contact thermosensible (6),
dans lequel le deuxième pôle du composant de protection contre les surtensions (2) est relié électriquement par l'intermédiaire du deuxième élément de connexion (4) à un élément conducteur de courant du support (5), et
dans lequel, en cas de surcharge thermique, ledit au moins un composant de protection contre les surtensions (2) peut être amené par ledit au moins un actionneur (7) dans une deuxième position dans laquelle le contact électrique passant par l'élément de contact thermosensible (6) est interrompu, et
dans lequel le deuxième élément de connexion (4) est réalisé et disposé de façon à permettre le mouvement du composant de protection contre les surtensions (2) de la première position à la deuxième position.

2. Agencement de protection contre les surcharges (1) selon la revendication 1, **caractérisé en ce que** le deuxième élément de connexion (4) est réalisé et disposé de façon à soutenir le mouvement du composant de protection contre les surtensions (2) de la première position à la deuxième position.

3. Agencement de protection contre les surcharges (1) selon la revendication 1 ou 2, **caractérisé en ce que** ledit au moins un actionneur (7) est configuré et disposé de façon à déplacer ledit au moins un composant de protection contre les surtensions (2) le long de la surface du support (5).

4. Agencement de protection contre les surcharges (1) selon l'une quelconque des revendications 1 à 3, **caractérisé en ce que** l'actionneur (7) est réalisé en tant qu'élément faisant ressort, de préférence en tant que ressort de pression ou de ressort de traction.

5. Agencement de protection contre les surcharges (1) selon l'une quelconque des revendications 1 à 4, **caractérisé en ce qu'**au moins un élément de maintien est prévu qui maintient le composant de protection contre les surtensions (2) substantiellement dans la deuxième position après une surcharge thermique.

6. Agencement de protection contre les surcharges (1) selon la revendication 5, **caractérisé en ce que** le deuxième élément de connexion (4) et/ou l'actionneur (7) est/sont réalisé(s) en tant qu'élément de maintien.

7. Agencement de protection contre les surcharges (1) selon l'une quelconque des revendications 1 à 6, **caractérisé en ce que** le deuxième élément de connexion (4) est réalisé sous la forme d'un élément de connexion pliable qui présente de préférence au moins une courbure.

8. Agencement de protection contre les surcharges (1) selon l'une quelconque des revendications 1 à 7, **caractérisé en ce que** le deuxième élément de connexion (4) est réalisé sous la forme d'un toron flexible et/ou d'une tôle flexible et/ou d'un élément de ressort de traction et/ou d'un élément de ressort de pression.

9. Agencement de protection contre les surcharges (1) selon l'une quelconque des revendications 1 à 7, **caractérisé en ce que** le deuxième élément de connexion (4) est réalisé sous la forme d'un actionneur (7).

10. Agencement de protection contre les surcharges (1) selon l'une quelconque des revendications 1 à 9, **caractérisé en ce que** dans la première position, ledit au moins un composant de protection contre les surtensions (2) est disposé sous précontrainte mécanique.

11. Agencement de protection contre les surcharges (1) selon l'une quelconque des revendications 1 à 10, **caractérisé en ce que** le composant de protection contre les surtensions (2) et le support (5) sont disposés au moins partiellement dans un boîtier (8), dans lequel un moyen d'affichage (11) est prévu dont la position permet d'identifier depuis l'extérieur du boîtier (8) si le composant de protection contre les surtensions (2) est disposé dans la première ou dans la deuxième position.

12. Agencement de protection contre les surcharges (1) selon la revendication 11, **caractérisé en ce que** le moyen d'affichage (11) est disposé au niveau du composant de protection contre les surtensions (2) et/ou **en ce que** le moyen d'affichage (11) est relié en tant que composant séparé au composant de protection contre les surtensions (2).

13. Agencement de protection contre les surcharges (1) selon l'une quelconque des revendications 1 à 12, **caractérisé en ce qu'**un deuxième composant de protection contre les surtensions (2) est disposé sur le support (5) par l'intermédiaire de deux autres éléments de connexion (3, 4),
dans lequel le premier élément de connexion (3) du deuxième composant de protection contre les surtensions (2) comprend un élément de contact thermosensible (6),
dans lequel, dans la première position, le deuxième composant de protection contre les surtensions (2) est relié au support (5) par son premier pôle par l'intermédiaire de l'élément de contact thermosensible (6) de telle sorte qu'une liaison électrique avec le circuit électrique à protéger est établie par l'intermédiaire de l'élément de contact thermosensible (6),
dans lequel en outre le deuxième pôle du deuxième composant de protection contre les surtensions (2) est relié à un élément conducteur de courant du support (5) par l'intermédiaire du deuxième élément de connexion (4),
dans lequel, en cas de surcharge thermique, le deuxième composant de protection contre les surtensions (2) peut être amené par un actionneur (7) dans une deuxième position dans laquelle le contact électrique passant par l'élément de contact thermosensible (6) est interrompu,
dans lequel le deuxième élément de connexion (4) est réalisé et disposé de façon à permettre le mouvement du composant de protection contre les surtensions (2) de la première position à la deuxième position,
dans lequel le support (5) et le premier composant de protection contre les surtensions (2) et le deuxième composant de protection contre les surtensions (2) sont disposés au moins partiellement dans un boîtier (8), et
dans lequel un moyen d'affichage (11) est prévu, dans lequel la position du moyen d'affichage permet d'identifier depuis l'extérieur du boîtier (8) si au moins un composant de protection contre les surtensions (2) est disposé dans la deuxième position.
